**Europäisches Patentamt**

**European Patent Office**

**Office européen des brevets**

(19)

(11) Publication number: **0 146 356**
**B1**

(12) # EUROPEAN PATENT SPECIFICATION

(45) Date of publication of patent specification: **16.03.88**

(51) Int. Cl.⁴: **G 11 C 11/40**

(21) Application number: **84308726.3**

(22) Date of filing: **14.12.84**

(54) **Static memory cell having electrical elements on two levels.**

(30) Priority: **16.12.83 JP 238552/83**

(43) Date of publication of application:
**26.06.85 Bulletin 85/26**

(45) Publication of the grant of the patent:
**16.03.88 Bulletin 88/11**

(84) Designated Contracting States:
**DE FR GB**

(56) References cited:
**EP-A-0 029 099**

(73) Proprietor: **FUJITSU LIMITED**
**1015, Kamikodanaka Nakahara-ku**
**Kawasaki-shi Kanagawa 211 (JP)**

(72) Inventor: **Yamauchi, Takahiko c/o FUJITSU LIMITED**
**Patent Department 1015 Kamikodanaka**
**Nakahara-ku Kawasaki-shi Kanagawa 211 (JP)**

(74) Representative: **Sunderland, James Harry et al**
**HASELTINE LAKE & CO Hazlitt House 28**
**Southampton Buildings Chancery Lane**
**London WC2A 1AT (GB)**

Courier Press, Leamington Spa, England.

# Description

The present invention relates to a memory cell having electrical elements on two levels, for instance in a double polysilicon (polycrystalline silicon) structure for a static memory device.

A static memory device formed on a silicon chip (substrate) comprises a row and column array of memory cells, having n rows and n columns, and associated peripheral circuits such as a row decoder, a column decoder and sense amplifiers. In a static MOS (metal-oxide-semiconductor) memory cell employing transmission gate selection for example two static inverters, each comprising a resistor and a transistor, are wired cross-coupled so as to provide a flip-flop operation.

As the number of bits to be stored in a memory cell array increases, from 64 kilo bits to 256 kilo bits, for instance, a higher packing density of electrical elements on a memory chip is required. To meet this requirement, double polysilicon technology has been proposed. With this technology, the (electrical) elements of a memory cell are arranged in a double polysilicon layer structure formed on a chip, providing in a decrease in the area occupied by a memory cell on the chip and an increase in packing density by a factor of approximately two.

As the number of memory cells on one chip increases, the standby current of the memory device increases, resulting in higher power consumption.

In recent times proposals for improvements in peripheral circuits of memory chips have been made with a view to reducing power consumption by the peripheral circuits, for example by the use of CMOS transistors and other technologies. However, the inventor has turned his attention to the reduction of memory cell current itself.

EP—A—29 099 discloses a static memory cell having the features mentioned in the precharacterising parts of claims 1 and 2. EP—A—29 099 teaches that parasitic capacitances formed between each resistor and its serially connected transistor should be eliminated. It teaches that a resistor should be formed over the gate of the other transistor (not serially connected to the resistor).

According to one aspect of the present invention there is provided a static memory cell comprising:

a first resistor and a first field effect transistor having a first gate electrode and source and drain regions, said first resistor and said first field effect transistor being connected in series at a first node;

a second resistor and a second field effect transistor having a second gate electrode and source and drain regions, said second resistor and said second field effect transistor being connected in series at a second node; and

a power supply line to which said first and second resistors are connected;

said first gate electrode being connected to said second node, said second gate electrode being connected to said first node;

said first resistor being positioned over said second gate electrode; characterised in that said second resistor is positioned over the one of said source or drain regions of said second field effect transistor which is connected to said second node.

According to another aspect of the present invention there is provided a static memory cell comprising:

a first resistor and a first field effect transistor having a first gate electrode and source and drain regions, said first resistor and said first transistor being connected in series at a first node;

a second resistor and a second field effect transistor having a second gate electrode and source and drain regions, said second resistor and said second field effect transistor being connected in series at a second node; and

a power supply line to which said first and second resistors are connected; said first gate electrode being connected to said second node, said second gate electrode being connected to said first node; characterised in that

said first resistor is positioned over the one of said source or drain regions of said first field effect transistor which is connected to said first node and said second resistor is positioned over the one of said source or drain regions of said second field effect transistor which is connected to said second node.

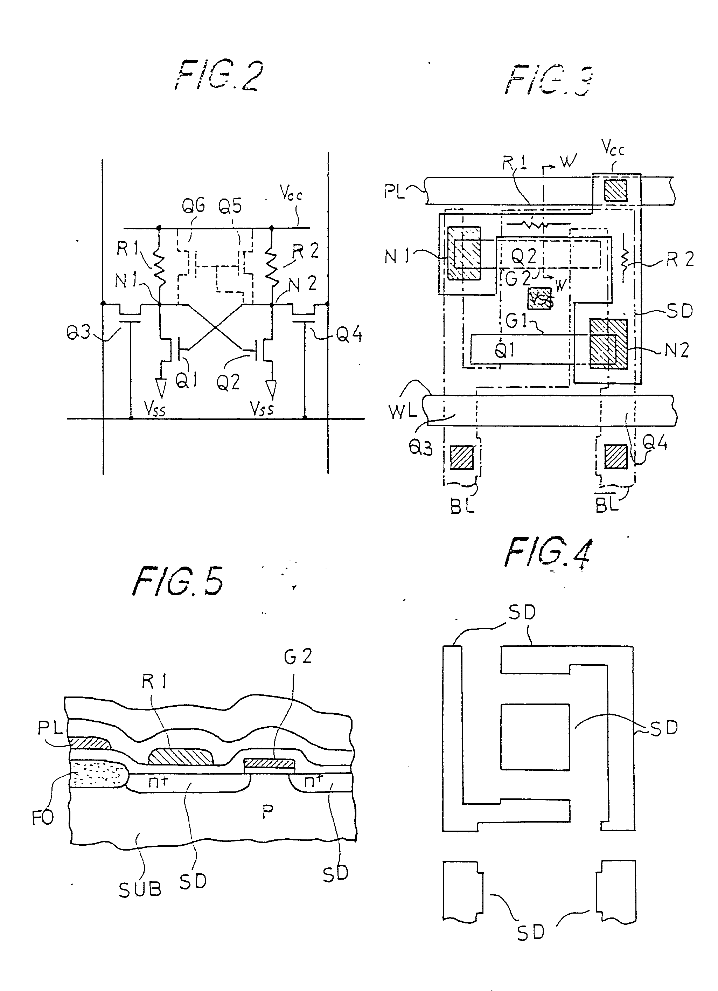

The inventor has recognised that, from the point of view of memory cell current, double polysilicon layer structure technology can be improved; that is, the double polysilicon layer structure has disadvantages. The inventor has realised that when the double polysilicon technology is adopted for a memory cell, undesirable effects occur due to the overlapping arrangement of electrical memory cell elements, such as the generation of parasitic transistors and parasitic capacitors. These effects are unavoidable and give rise to problems. For example, in the case of a static MOS memory cell employing transmission gate selection, as shown in the schematic circuit diagram of Fig. 2, which is formed with double polysilicon technology, two transistors (Q1, Q2) of the two inverters of the cell are formed in the memory chip directly, and two resistors (R1, R2) of the two inverters are formed on an insulator layer covering the transistors. These electric elements are wired to one another through contact holes opened in the insulator layer. As a result, the resistors are formed so as to encounter doped regions, namely source and drain regions of the transistors formed in the chip, and the insulator layer exist therebetween. Thus, the inventor has recognised, parasitic FETs (field effect transistors) Q5, Q6 are formed as depicted by broken lines in Fig. 2. The inventor has realised that these parasitic transistors are formed in parallel with the resistors R1, R2, allowing a current to flow, causing an increase in memory cell current.

Generally, a memory cell having electrical elements on two levels, for instance using double polysilicon technology, has undesirable parasitic transistors as identified above. Briefly, the arrangement of and fabrication steps for providing electrical elements of a double polysilicon technology memory cell are as follows. In a silicon substrate, source and drain regions (hereinafter SD regions) of transistors, herein enhanced (enhancement) type MOS FETs by way of example, are formed in a transistor region which is defined on the substrate (chip) by a field oxide layer, usually a thick silicon dioxide ($SiO_2$) layer. The substrate is covered entirely by a thin silicon dioxide ($SiO_2$) insulator layer which provides gate insulators for the transistors. Over the insulator layer, first polysilicon layers, providing gate electrodes of the transistors, word lines and power supply lines are formed. These polysilicon layers are covered with another insulator layer, and second polysilicon layers, providing resistors, are formed on this other insulator layer. In a previously proposed memory cell, the resistors are formed over SD regions (this is shown in Fig. 3, see below) because a flat surface having no step-difference is there available and is desirable for obtaining uniform and reliable layers using various fabricating processes such as an ion implantation method of doping, chemical vapour deposition, dry etching and the like. With the previously proposed memory cell structure described above, there occur zones whereat resistor polysilicon layer, insulator layer and SD region are laminated in that order. Thus parasitic transistors are formed in such zones. In the memory cell, for such parasitic transistors, a resistor layer acts as a channel region, the insulator layer acts as a gate insulator and an SD region acts as a gate electrode. Since such parasitic transistors are usually connected in parallel with the resistors, memory cell current is enhanced by the parasitic transistors.

The inventor has realised that the elimination of parasitic transistors (from a memory cell having a double polysilicon layer structure) is not necessasry to avoid memory cell current enhancement due to such parasitic transistors. The inventor has had the insight that the formation of parasitic transistors can be allowed but nevertheless the undesired effect of the parasitic transistors can be eliminated or reduced.

The inventor provides that this end can be accomplished by an apparently small and simple rearrangement of electrical elements of a memory cell which is nevertheless effective to achieve the desired result. With this rearrangement the gate electrode of each such parasitic transistor is connected commonly to its source region, making the parasitic transistor non-conductive.

An embodiment of the present invention can provide a memory cell of a static memory device having a structure providing a reduction in memory cell current.

An embodiment of the present invention can provide a memory cell having a double polysilicon structure with an effective layout of electrical elements such as to reduce or eliminate the effects of parasitic transistors which otherwise enhance memory cell current.

An embodiment of the present invention concerns the structure of a static memory cell, having a flip-flop circuit comprising two cross-coupled pairs of resistor-transistor inverters formed in double polysilicon layers.

Reference is made, by way of example, to the accompanying drawings, in which:-

Fig. 1 is a schematic partial block circuit diagram of a static MOS memory device, illustrating wiring of the memory matrix array of the memory device,

Fig. 2 is a schematic circuit diagram of a previously proposed memory cell circuit, comprising two resistors and two transistors, formed on a memory chip,

Fig. 3 is a schematic plan view of a previously proposed memory cell having a double polysilicon layer structure, illustrating the layout of electrical elements of the cell formed on a memory chip, and additionally showing parasitic transistors identified as being generated in the structure,

Fig. 4 corresponds to the plan view of Fig. 3, illustrating schematically the pattern of an SD region of the memory cell in the substrate (chip),

Fig. 5 is a partial cross-sectional view of the memory cell of Fig. 3,

Fig. 6 is a schematic circuit diagram of a memory cell circuit according to an embodiment of the present invention, illustrating a modified formation of parasitic transistors as compared with Fig. 2,

Fig. 7 is a schematic plan view of a memory cell in accordance with an embodiment of the present invention, realising the circuit (parasitic transistor) configuration of Fig. 6, illustrating the layout of electrical elements of the cell, showing in particular a modified location and pattern of resistors of the cell, as compared with Fig. 3,

Fig. 8 is a partial cross-sectional view of the memory cell of Fig. 7, illustrating modified resistor positioning, and

Fig. 9 is a schematic plan view of a memory cell in accordance with another embodiment of the present invention, also realizing the circuit (parasitic transistor) configuration shown in Fig. 6.

Before disclosing an embodiment of the present invention, general operation and construction of a memory device will be described.

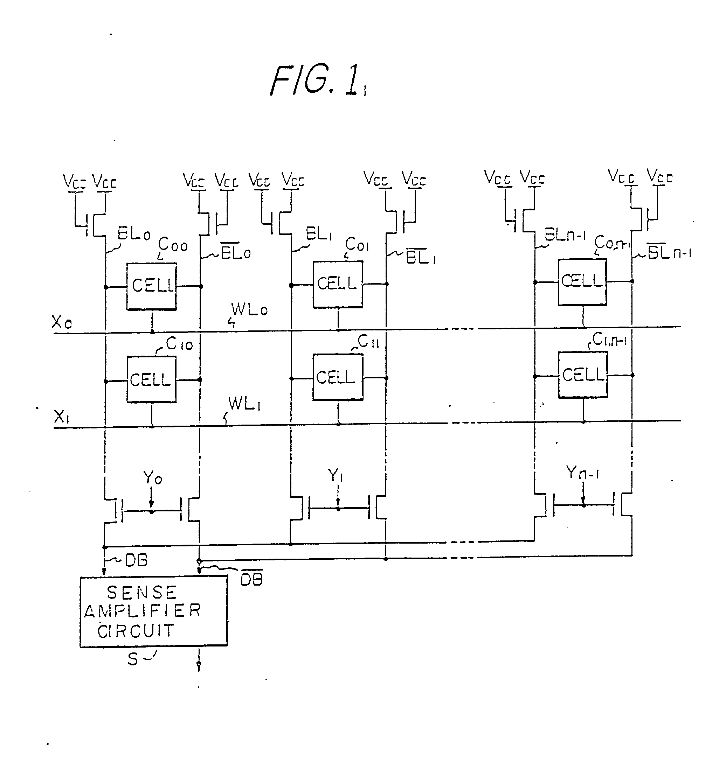

Fig. 1 is a partial schematic block circuit diagram of a static memory device formed on a chip. the device has a row and column array of memory cells of which cells $C_{oo}$ to $C_{1,n-1}$ are shown in Fig. 1. The device has word lines in correspondence to rows of the array. Word lines $WL_o$ and $WL_1$ are shown in Fig. 1. The device also has bit line pairs $BL_o$, $\overline{BL}_o$ to $BL_{n-1}$, $\overline{BL}_{n-1}$ in correspondence to columns of the array. Data bit lines DB and $\overline{DB}$ are selectively connectible to the bit line pairs and are connected to a sense amplifier circuit S. $V_{cc}$ represents a power supply voltage.

When a memory cell $C_{11}$ in the 1st row and 1st column is selected, the potential of a row address signal $X_1$, and accordingly the potential at word line $WL_1$, is changed from low to high by a row decoder (not shown) and the potential of a column address signal $Y_1$ is changed from low to high by a column decoder (not shown). Accordingly, bit lines $BL_1$ and $\overline{BL}_1$ are connected to data bit lines DB and $\overline{DB}$ respectively. The output of the memory cell $C_{11}$ is fed to a sense amplifier S and sensed and amplified to TTL level.

Fig. 2 is a circuit diagram illustrating a previously proposed memory cell which can be used in the memory cell matrix array. The memory cell has MOS transistors $Q_1$, $Q_2$ and resistors $R_1$, $R_2$, which are cross-coupled in a flip-flop arrangement. MOS transistors $Q_3$, $Q_4$ provide a transmission gate function (to selectively connect nodes $N_1$ and $N_2$ to bit lines—running vertically on left and right sides of Fig. 2 in dependence upon the potential of a word line-running horizontally at the bottom of Fig. 2).

Resistor $R_1$ and transistor $Q_1$ are connected in series with node $N_1$ as their common connection point. Resistor $R_2$ and transistor $Q_2$ are connected in series with node $N_2$ as their common connection point. The ends of resistors $R_1$ and $R_2$ not connected to nodes $N_1$ and $N_2$ are connected to a power supply line $V_{cc}$. The gate of $Q_1$ is connected to $N_2$. The gate of $Q_2$ is connected to $N_1$. $V_{ss}$ is another power supply line (e.g. ground).

Corresponding to a memory cell state "0", the potentials at node $N_2$ and node $N_1$ are high and low respectively. Accordingly, MOS transistor $Q_1$ is conductive and an MOS transistor $Q_2$ is non-conductive. MOS transistors $Q_3$ and $Q_4$ are made conductive by high potentials applied to their gates through the word line.

The memory cell can be constructed with a double polysilicon structure as mentioned above. A schematic plan view of such structure of this previously proposed memory cell is shown in Fig. 3, and a cross-sectional view, taken along line W—W of Fig. 3, is shown in Fig. 5, illustrating the mutual positional relationship of the transistor $Q_2$ and the resistor $R_1$.

In the memory cell of Figs. 2 to 5, the inventor has realised that parasitic transistors $Q_5$ and $Q_6$ are formed as depicted by broken lines in Fig. 2.

It should be noted that with this arrangement of electrical elements, the gates of parasitic transistors are commonly connected to the node $N_2$. The connection of the gate electrodes of the parasitic transistors $Q_5$ and $Q_6$ will be described in more detail below.

Since the potential of node $N_2$ is high in a memory cell state "0", the parasitic transistor $Q_6$ and the transistor $Q_1$ are both conductive, resulting in an increase in the current flowing through the $R_1$—$Q_1$ circuit. This leads to an enhancement of the memory cell current. In this memory cell state, in the $R_2$—$Q_2$ circuit, the transistor $Q_2$ is non-conductive and no current flows.

When the memory cell is in a "1" state, the potentials of the nodes $N_2$ and $N_1$ are low and high respectively. No current flows through the $R_1$—$Q_1$ circuit because the transistor $Q_1$ is non-conductive. On the other hand, in the $R_2$—$Q_2$ circuit, the transistor $Q_2$ is conductive and a current flows through the resistor $R_2$ and transistor $Q_2$, but the potential of the gate electrode of the parasitic transistor $Q_5$ is low (the potential of node $N_2$) and the parasitic transistor $Q_5$ is non-conductive, resulting in no enhancement of the memory cell circuit. In other words, the gate electrode of the parasitic transistor $Q_5$ is commonly connected to its own source contact, the connection of which always makes the enhancement type MOS transistor non-conductive.

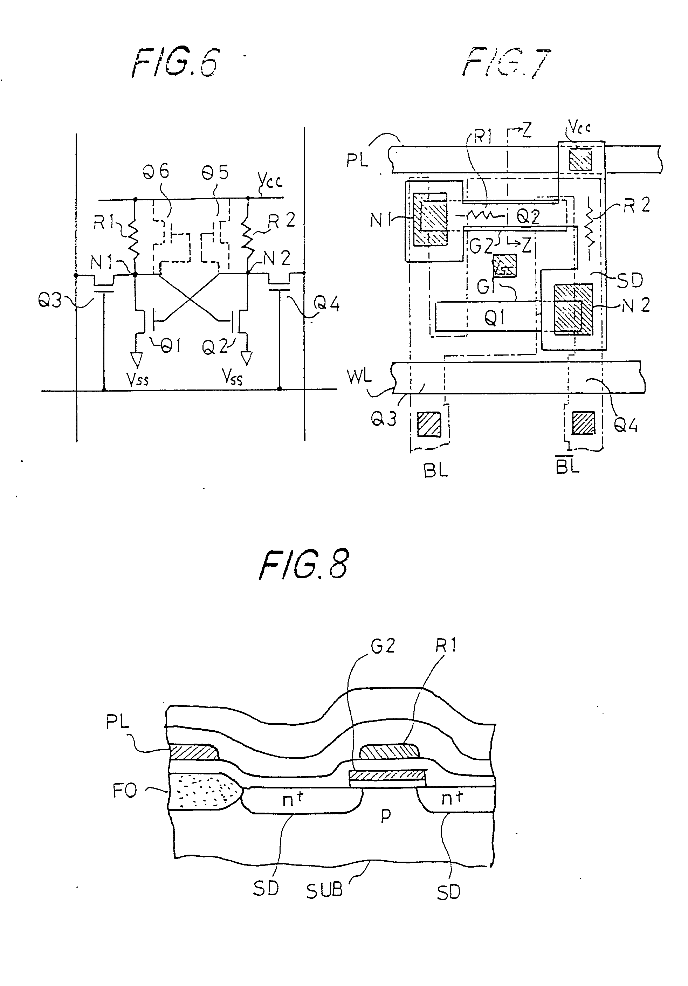

The inventor has realised that if the gate electrode of the parasitic transistor $Q_6$ is also commonly connected to the source contact of the transistor $Q_6$, as shown in Fig. 6, the transistor $Q_6$ would always remain non-conductive and the problem of enhanced memory cell current due to parasitic transistors would not occur. To achieve this, the inventor proposes an improved memory cell structure, a plan view of an example of which is given in Fig. 7. A cross-sectional view taken along the line Z—Z of Fig. 7 is given in Fig. 8.

The present invention provides an elegant and subtle improvement of memory cell structure which affords a reduction in memory cell current. To clarify the advantages of the present invention over the previous proposed memory cell structure, the memory cell of Figs. 3 to 5 and its associated fabrication steps will be described briefly. Herein, the memory device will be assumed to be a static n-type MOS memory.

The fabrication of a static n-MOS memory cell begins with the formation of a field oxide layer, a thick silicon dioxide $(SiO_2)$ layer FO (see Fig. 5), over a p-type silicon substrate SUB (see Fig. 5), defining transistor regions wherein enhanced (enhancement) type MOS transistors (e.g. $Q_1$, $Q_2$) are to be formed. A thin silicon dioxide $(SiO_2)$ layer for providing transistor gate insulator layers is formed over the entire surface of the substrate SUB. Following this step, polysilicon layers for providing gate electrodes $G_1$ (see Fig. 3) and $G_2$ (see Figs. 3 and 5) of the transistors $Q_1$ and $Q_2$, word lines WL (Fig. 3) and power supply lines PL (Figs. 3 and 5) are formed selectively using a mask, covering the channel regions of all the transistors $Q_1$ to $Q_4$. This is the first polysilicon layer formation. Except for portions thereof underneath the gate electrodes $G_1$ and $G_2$, word lines WL and power lines PL, the thin silicon dioxide layer for providing transistor gate insulator layers is removed by etching to expose the original silicon substrate SUB. The exposed zones of the substrate are heavily ion implanted with n-type dopants utilizing a mask to provide a predetermined profile. Naturally, the field oxide layer FO, gate electrodes $G_1$ and $G_2$ and word lines WL have a masking function. The implanted dopants are diffused to form n-type SD regions for the transistors as shown by chain lines in Fig. 3. Zones of the substrate beneath the gate electrodes $G_1$ and $G_2$ and the word line WL are not doped by the n-type dopants, remaining as p-type channel regions for the transistors $Q_1$ to $Q_4$. For clarity, Fig. 4 shows only the layout of the diffused SD regions formed in the substrate SUB. Next, the entire substrate is covered with insulator layers of silicon dioxide ($SiO_2$) and silicon nitride. This is followed by the opening of contact windows for nodes $N_1$ and $N_2$, and power supply lines PL. These windows are shown as hatched squares in Fig. 3. Then a polysilicon layer for providing resistors $R_1$ and $R_2$ is formed over the insulator layer. This is the second polysilicon layer formation. Through the windows, connections of the resistors $R_1$ and $R_2$ to nodes $N_2$ and $N_1$, and to the power supply line PL are accomplished. As illustrated in Fig. 3, narrow polysilicon layer portions signified by zig-zag lines (resistor symbols) serve as the resistors $R_1$ and $R_2$. After this step, an insulator layer is formed over the entire substrate and windows for bit lines BL and $\overline{BL}$, and a window for the second power supply line Vss (not shown), are opened in that insulator layer, followed by formation of wiring on the surface of that insulator layer. Thus the electrical elements and wiring of memory cells are completed.

Apparently, both resistors $R_1$ and $R_2$ overlie the SD region connected to the node $N_2$, underneath the insulator layer. There are thus formed laminated layer structures each of which comprises a polysilicon layer resistor, a silicon dioxide ($SiO_2$) insulator layer and n-type doped SD region, in that order. Thus the laminated layer structures act as parasitic transistors $Q_5$ and $Q_6$ as shown in Fig. 2, whereby SD region, insulator layer and resistor layer ($R_1$ or $R_2$) play the roles of gate electrode, gate insulator and channel region respectively. It should be noted that the gate electrodes of both parasitic transistors $Q_5$ and $Q_6$, namely the SD region of the transistor $Q_2$, are connected to the node $N_2$ together. This means that the gate electrode of the parasitic transistor $Q_5$ is commonly connected to its source contact side (node $N_2$), so that the parasitic transistor $Q_5$ is always non-conductive regardless of the potential of the node $N_2$, high or low. On the other hand, the gate electrode of the parasitic transistor $Q_6$ is not connected to the source contact of $Q_6$, but to the node $N_2$ (to the drain region of the parasitic transistor $Q_6$—If the gate electrode is commonly connected to the drain region of the parasitic transistor, the parasitic transistor is conductive and allows current to flow) and the parasitic transistor $Q_6$ is controlled by the potential of the node $N_2$. Corresponding to the state of "0" of the memory cell, where the potential of the node $N_2$ is high level, the parasitic transistor $Q_6$ becomes conductive and a current flows in parallel with a current of the resistor $R_1$. In other words, it can be said that the effective resistance of the resistor $R_1$ is reduced, resulting in an increase of memory cell current.

Without completely avoiding the formation of parasitic transistors, which the inventor believes would be difficult if not impossible in a memory cell having a double polysilicon structure, a solution to the identified problem of enhanced memory cell current arising due to the parasitic transistors is provided by the inventor by giving a reduction or elimination of the effects of the parasitic transistors, by making the parasitic transistors $Q_5$ and $Q_6$ non-conductive regardless of the state "1" or "0" of the memory cell. This can be done by connecting the gate electrode of each parasitic transistor commonly to the source contact of the transistor as shown in a circuit diagram of Fig. 6, where the gate electrode of the parasitic transistor $Q_6$ is connected to the node $N_1$.

Now a memory cell structure in accordance with an embodiment of the present invention will be described. Fig. 7 is a schematic plan view of the memory cell structure and Fig. 8 is a partial cross-sectional view taken along the line Z—Z in Fig. 7.

In this structure the resistor $R_1$ is formed over the gate electrode $G_2$ and not over the SD region of the MOS transistors of the memory cell. This is a minor modification with regard to the totality of the fabrication of a memory device, because the new arrangement of the resistor $R_1$ is obtained by changing the pattern of a mask used for the second polysilicon layer formation. With the layout of Fig. 7, the parasitic transistor $Q_6$ is provided by a laminated layer structure composed of resistor $R_1$, insulator layer and gate electrode $G_2$ which act as a channel region, gate insulator and gate electrode of the parasitic transistor $Q_6$ respectively. Since the gate electrode $G_2$ and resistor $R_1$ are connected to the node $N_1$, the gate electrode and the source contact of the parasitic transistor $Q_6$ are commonly connected thereby realizing the circuit shown in Fig. 6. Thus the parasitic transistor $Q_6$ is kept non-conductive during flip-flop operation of the memory cell.

From the point of view of fabrication, the positioning of the resistor $R_1$ over the gate electrode $G_2$ induces a small drawback for the formation of the second polysilicon layer, namely the resistor $R_1$, as compared with the previously proposed memory cell structure. the flatness of the surface whereon the second polysilicon layer is to be formed (to provide resistor $R_1$), is rather worse than that of the surface whereon the resistor $R_1$ is formed in the previously proposed memory cell structure, as can be seen from Fig. 8. However, this drawback can be overcome by modern MOS device fabrication technology.

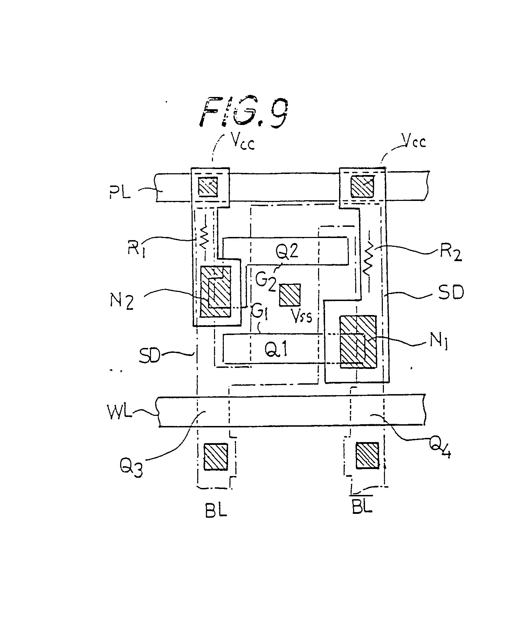

Another memory cell structure in accordance with an embodiment of the present invention is shown in a plan view of Fig. 9. The resistors $R_1$ and $R_2$ are formed separated (remote) from each other as shown in Fig. 9. The transistor-resistor pairs making up the circuits $R_1$—$Q_1$ and $R_2$—$Q_2$ are connected to nodes $N_2$ and $N_1$ respectively. With the laminated layer structure of Fig. 9 parasitic transistor $Q_6$ is composed of resistor $R_1$, insulator layer and a zone of the SD region, which act as channel region, gate insulator and gate electrode of the parasitic transistor. This zone of the SD region is connected to the node $N_1$ (differently from the zone of the SD region forming parasitic transistor $Q_5$ which is connected to node $N_2$—see e.g. Fig. 4). The layout and wiring of Fig. 9 provide parasitic transistors $Q_5$ and $Q_6$

respectively with commonly connected gate electrodes and source contacts, realizing the circuit arrangement of Fig. 6. The slight fabrication drawback of the structure of Fig. 7 is also avoided.

The structures in accordance with embodiments of the present invention as described above relate to n-type static MOS memory devices, but it will be clear to those skilled in the art that the present invention is also applicable to p-type MOS memory devices.

## Claims

1. A static memory cell comprising:
a first resistor (R1) and a first field effect transistor (Q1) having a first gate electrode and source and drain regions (SD), said first resistor and said first field effect transistor being connected in series at a first node (N1);
a second resistor (R2) and a second field effect transistor (Q2) having a second gate electrode and source and drain regions (SD), said second resistor and said second field effect transistor being connected in series at a second node (N2); and
a power supply line (VCC) to which said first and second resistors are connected;
said first gate electrode being connected to said second node, said second gate electrode being connected to said first node;
said first resistor (R1) being positioned over said second gate electrode; characterised in that said second resistor (R2) is positioned over the one of said source or drain regions of said second field effect transistor (Q2) which is connected to said second node (N2).

2. A static memory cell comprising:
a first resistor (R1) and a first field effect transistor (Q1) having a first gate electrode and source and drain regions (SD), said first resistor and said first transistor being connected in series at a first node (N1);
a second resistor (R2) and a second field effect transistor (Q2) having a second gate electrode and source and drain regions (SD), said second resistor and said second field effect transistor being connected in series at a second node (N2); and
a power supply line (VCC) to which said first and second resistors are connected;
said first gate electrode being connected to said second node, said second gate electrode being connected to said first node; characterised in that said first resistor (R1) is positioned over the one of said source or drain regions of said first field effect transistor (Q1) which is connected to said first node (N1), and said second resistor (R2) is positioned over the one of said source or drain regions of said second field effect transistor (Q2) which is connected to said second node (n2).

## Patentansprüche

1. Statische Speicherzelle mit:
einem ersten Widerstand (R1) und einem ersten Feldeffekttransistor (Q1), der eine erste Gateelektrode und Source- und Drain-Bereiche (SD) hat, welcher genannte erste Widerstand und welcher genannte erste Feldeffekttransistor bei einem ersten Knotenpunkt (N1) in Reihe verbunden sind;
einem zweiten Widerstand (R2) und einem zweiten Feldeffekttransistor (Q2), der eine zweite Gateelektrode und Source- und Drain-Bereiche (SD) hat, welcher genannte zweite Widerstand und welcher genannte zweite Feldeffekttransistor bei einem zweiten Knotenpunkt (N2) in Reihe verbunden sind; und
einer Energieversorgungsleitung (VCC), mit der die genannten ersten und zweiten Widerstände verbunden sind;
wobei die genannte erste Gateelektrode mit dem genannten zweiten Knotenpunkt verbunden ist, die genannte zweite Gateelektrode mit dem genannten ersten Knotenpunkt verbunden ist;
wobei der erste Widerstand (R1) über der genannten zweiten Gateelektrode positioniert ist;
dadurch gekennzeichnet, daß der genannte zweite Widerstand (R2) über dem einen der genannten Source- oder Drain-Bereiche des genannten zweiten Feldeffekttransistors (Q2) positioniert ist, der mit dem genannten zweiten Knotenpunkt (N2) verbunden ist.

2. Statische Speicherzelle mit:
einem ersten Widerstand (R1) und einem ersten Feldeffekttransistor (Q1), der eine erste Gateelektrode und Source- und Drainbereiche (SD) hat, welcher genannte erste Widerstand und welcher genannte erste Feldeffekttransistor bei einem ersten Knotenpunkt (N1) in Reihe verbunden sind;
einem zweiten Widerstand (R2) und einem zweiten Feldeffekttransistor (Q2), der eine zweite Gateelektrode und Source- und Drain-Bereiche (SD) hat, welcher genannte zweite Widerstand und welcher genannte zweite Feldeffekttransistor bei einem zweiten Knotenpunkt (N2) in Reihe verbunden sind; und
einer Energieversorgungsleitung (VCC), mit der die genannten ersten und zweiten Widerstände verbunden sind;
wobei die genannte erste Gateelektrode mit dem genannten zweiten Knotenpunkt verbunden ist, die zweite Gateelektrode mit dem genannten ersten Knotenpunkt verbunden ist; dadurch gekennzeichnet, daß
der erste Widerstand (R1) über dem einen der genannten Source- oder Drainbereiche des genannten ersten Feldeffekttransistors (Q1) positioniert ist, der mit dem genannten ersten Knotenpunkt (N1) verbunden ist, und der genannte zweite Widerstand (R2) über dem einen der genannten Source- oder Drainbereiche des genannten zweiten Feldeffekttransistors (Q2) positioniert ist, der mit dem genannten zweiten Knotenpunkt (N2) verbunden ist.

## Revendications

1. Cellule de mémoire statique comprenant:

une première résistance (R1) et un premier transistor à effet de champ (Q1) comportant une première électrode de grille et des régions de source et de drain (SD), la première résistance et le premier transistor à effet de champ étant connectés en série à un premier noeud (N1);

une deuxième résistance (R2) et un deuxième transistor à effet de champ (Q2) comportant une deuxième électrode de grille et des régions de source et de drain (SD), la deuxième résistance et le deuxième transistor à effet de champ étant connectés en série à un deuxième noeud (N2); et

une ligne de tension d'alimentation (VCC) à laquelle des première et deuxième résistances sont connectées;

la première électrode de grille étant connectée au deuxième noeud, la deuxième électrode de grille étant connectée au premier noeud;

la première résistance (R1) étant positionnée sur la deuxième électrode de grille; caractérisée en ce que

la deuxième résistance (R2) est positionnée sur celle des régions de source et de drain du deuxième transistor à effet de champ (Q2) qui est connectée au deuxième noeud (N2).

2. Cellule de mémoire statique comprenant:

une première résistance (R1) et un premier transistor à effet de champ (Q1) comportant une première électrode de grille et des régions de source et de drain (SD), la première résistance et le premier transistor étant connectés en série à un premier noeud (N1);

une deuxième résistance (R2) et un deuxième transistor à effet de champ (Q2) comportant une deuxième électrode de grille et des régions de source et de drain (SD), la deuxième résistance et le deuxième transistor à effet de champ étant connectés en série à un deuxième noeud (N2); et

une ligne de tension d'alimentation (VCC) à laquelle sont connectées les première et deuxième resistances;

la première électrode de grille étant connectée au deuxième noeud, la deuxième électrode de grille étant connectée au premier noeud; caractérisée en ce que

la première résistance (R1) est positionnée sur celle des régions de source et de drain du premier transistor à effet de champ (Q1) qui est connectée au premier noeud (N1), et la deuxième résistance (R2) est positionnée sur celle des régions de source et de drain du deuxième transistor à effet de champ (Q2) qui est connectée au deuxième noeud (N2)

0 146 356

# FIG. 1

1

FIG.2

FIG.3

FIG.5

FIG.4

# FIG.6

# FIG.7

# FIG.8

# FIG.9